# DEMANDE DE BREVET EUROPEEN

(11) **EP 1 953 116 A2**
(43) Date de publication de la demande: **06.08.2008**
(21) Numéro de dépôt: 08354005.4
(22) Date de dépôt: 22.01.2008
(51) Int. Cl.: B81B 3/00

(54) **Microsystème d'actionnement et procédé de fabrication associé**

(30) Priorité: 05.02.2007 FR 0700801
(71) Demandeur: COMMISSARIAT A L'ENERGIE ATOMIQUE, 75015 Paris (FR)
(72) Inventeur: Sibuet, Henry, 38120 Le Fontanil (FR); Dieppedale, Christel, 38920 Crolles (FR)
(74) Mandataire: Jouvray, Marie-Andrée

(57) **Abrégé**

Le microsystème d'actionnement (1) est réalisé sur un substrat plan (2) et comporte un bras pivotant (3), monté en rotation autour d'une charnière (4), un plot de contact fixe (6), disposé sur le substrat (2), et une butée de fin de course (7) d'ouverture du bras pivotant (3). La butée de fin de course (7) comporte une partie supérieure, par exemple, une tête (9), disposée au-dessus et à distance du bras pivotant (3), entre une extrémité d'articulation (3c) et une extrémité libre (3d) du bras pivotant (3). La butée (7) comporte une partie inférieure, disposée latéralement par rapport au bras pivotant (3), entre la charnière (4) et le plot de contact fixe (6), et constituée, par exemple, par un pied (8) comportant un plot de support (10), formé sur le substrat (2), un piédestal (11) prolongeant le plot de support (10) et une portion de support (12) de la tête (9).

## Description

### Domaine technique de l'invention

L'invention concerne un microsystème d'actionnement réalisé sur un substrat plan et comportant au moins :
- un bras pivotant, monté en rotation autour d'une charnière formée sur le substrat,
- un premier plot de contact fixe, disposé sur une surface supérieure du substrat et coopérant avec au moins un plot de contact mobile, solidaire du bras pivotant,
- et une butée de fin de course d'ouverture du bras pivotant.

L'invention concerne également un procédé de fabrication d'un tel microsystème.

### État de la technique

Les demandes de brevet US 2003/0173957 et US 2005/0083156 et le brevet US 6 750 745 décrivent chacun un microsystème d'actionnement, plus particulièrement un dispositif interrupteur de circuit électrique, au moyen d'un élément magnétique mobile. De tels dispositifs sont fabriqués au moyen de procédés issus de la microélectronique donnant une bonne capacité d'intégration, visant ainsi à abaisser les coûts de fabrication en préservant une bonne maîtrise de la fabrication.

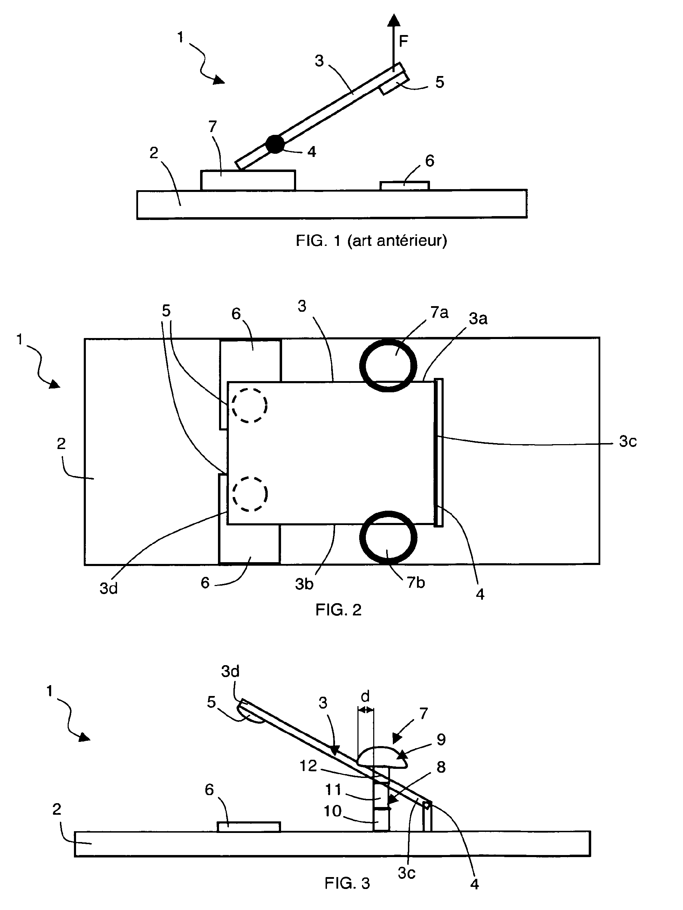

Comme représenté très schématiquement sur la figure 1, un tel microsystème d'actionnement 1, selon l'art antérieur, est réalisé sur un substrat plan 2 et comporte un bras pivotant 3, monté en rotation et articulé autour d'une charnière 4, supportée par le substrat 2. Le bras pivotant 3 est actionné, par exemple, par une force magnétique verticale F, orientée vers le haut perpendiculairement au substrat 2, et comporte un plot de contact mobile 5, solidaire de la face inférieure du bras pivotant 3, destiné à venir en contact avec un plot de contact fixe 6, réalisé sur la surface supérieure du substrat 2.

La question du blocage de la rotation du bras pivotant 3 a été posée, notamment en vue d'imposer une limite d'élasticité au niveau de la charnière 4, pour éviter une déformation excessive du bras pivotant 3, qui conduirait à un vieillissement accéléré du microsystème 1. La demande de brevet US 2005/0083156 décrit notamment la nécessité d'utiliser un mécanisme de blocage, par exemple une butée de fin de course, pour maîtriser l'ouverture du bras pivotant 3. Comme représenté sur la figure 1, une butée de fin de course 7 d'ouverture du bras pivotant 3 est réalisée sur le substrat 2 et placée sensiblement à l'arrière de la charnière 4. L'extrémité du bras pivotant 3 opposée à l'extrémité comportant le plot de contact mobile 5 vient alors en appui sur la butée de fin de course 7, afin de bloquer la rotation du bras pivotant 3.

Cependant, ce type de butée n'est pas satisfaisant, car il ne vise qu'un positionnement approximatif du bras pivotant et ne permet pas de limiter efficacement les efforts appliqués au niveau de la charnière.

Le document US-A1-2709791 décrit la réalisation d'un interrupteur qui comporte un dispositif d'arrêt pour limiter le déplacement d'un élément mobile.

### Objet de l'invention

L'invention a pour but de remédier à l'ensemble des inconvénients précités et a pour objet la réalisation d'un microsystème d'actionnement comportant une butée de fin de course d'ouverture d'un bras pivotant, qui soit efficace, qui n'altère pas le fonctionnement du microsystème, et qui permette de maîtriser la rotation du bras pivotant.

Selon l'invention, ce but est atteint par les revendications annexées et, plus particulièrement, par le fait que la butée de fin de course, formée sur le substrat, comporte :
- une partie supérieure disposée au-dessus et à distance du bras pivotant, entre une extrémité d'articulation du bras pivotant sur la charnière et une extrémité libre du bras pivotant, comportant le plot de contact mobile,
- une partie inférieure, reliée au substrat et disposée latéralement par rapport au bras pivotant, entre la charnière et le plot de contact fixe.

L'invention a également pour objet un procédé de réalisation d'un tel microsystème, qui soit simple, rapide et économique.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 représente très schématiquement une vue de face d'un microsystème d'actionnement, avec une butée de fin de course d'ouverture d'un bras pivotant, selon l'art antérieur.
Les figures 2 et 3 représentent schématiquement, respectivement, une vue de dessus et une vue de face d'une première variante de réalisation d'un microsystème d'actionnement, avec une butée de fin de course d'ouverture d'un bras pivotant, selon l'invention.
Les figures 4 à 8 sont des vues de face représentant schématiquement différentes étapes successives d'un procédé de fabrication d'un microsystème d'actionnement selon les figures 2 et 3.
Les figures 9 et 10 représentent schématiquement, respectivement, une vue de dessus et une vue de face d'une deuxième variante de réalisation d'un microsystème d'actionnement, avec une butée de fin de course d'ouverture d'un bras pivotant, selon l'invention.
Les figures 11 à 13 sont des vues de face représentant schématiquement différentes étapes successives d'un procédé de fabrication d'un microsystème d'actionnement selon les figures 9 et 10.

### Description de modes particuliers de réalisation

Dans le premier mode particulier de réalisation de l'invention représenté sur les figures 2 à 8, le microsystème d'actionnement 1 selon l'invention comporte le bras pivotant 3, par exemple en forme de plaque ayant deux bords longitudinaux 3a et 3b, montée en rotation autour de la charnière 4 au niveau d'une extrémité d'articulation 3c. Le bras pivotant 3 comporte, par exemple, deux plots de contact mobiles 5, placés au niveau d'une extrémité libre 3d du bras pivotant 3, opposée à l'extrémité d'articulation 3c, solidaires de la surface inférieure du bras pivotant 3 et destinés à coopérer avec, par exemple, deux plots de contact fixes 6, réalisés sur la surface supérieure du substrat 2.

Le microsystème 1 comporte, par exemple, deux butées de fin de course 7a, 7b d'ouverture du bras pivotant 3 (figure 2), formées sur le substrat, disposées de part et d'autre du bras pivotant 3 et sur lesquelles viennent en butée, respectivement, les bords longitudinaux 3a, 3b du bras pivotant 3, afin de bloquer la rotation du bras pivotant 3.

Sur les figures 2 et 3, la description qui va suivre concerne une butée de fin de course 7 et s'applique pour les deux butées de fin de course 7a ,7b. La butée de fin de course 7 comporte un pied 8 et une tête 9, définissant une butée sensiblement en forme de champignon, faisant saillie au moins partiellement au-dessus du bord longitudinal 3a, 3b correspondant du bras pivotant 3. Le pied 8 de la butée 7 est disposé entre la charnière 4 et le plot de contact fixe 6, réalisés sur le substrat 2 (figure 2), et le pied 8 est constitué en trois parties.

Sur la figure 3, la première partie du pied 8 est un plot de support 10, formé sur le substrat 2 et, de préférence, dans un même matériau que la charnière 4, notamment tout matériau qui ne se dégrade pas pendant la libération par gravure du bras pivotant 3 lors du procédé de fabrication comme décrit ci-après. La deuxième partie du pied 8 est un piédestal 11, prolongeant le plot de support 10 et formé, de préférence, dans un même matériau que le bras pivotant 3. La troisième partie du pied 8 est une portion de support 12 de la tête 9, formée, de préférence, dans un même matériau que la tête 9.

La tête 9 de la butée de fin de course 7 est, par exemple, bombée, pour définir sensiblement la forme caractéristique d'un chapeau de champignon, et fait saillie au-dessus du bord longitudinal 3a, 3b associé du bras pivotant 3, afin de bloquer la rotation du bras pivotant 3 et donc servir de butée de fin de course, pour l'ouverture du bras pivotant 3. La forme caractéristique en champignon de la tête 9 de la butée de fin de course 7 est obtenue avantageusement par dépôt électrolytique d'un matériau compatible avec ce type de procédé, notamment tout matériau métallique, apte à supporter les étapes de gravure permettant la libération du microsystème comme décrit ci-après.

À titre d'exemple, la tête 9 et la portion de support 12 de la tête 9 sont en fer, en nickel, en or, en chrome ou en tout alliage comportant au moins deux de ces matériaux. La portion de support 12 de la tête 9 a une épaisseur de l'ordre de 1*µ*m à 5*µ*m. Le bras pivotant 3 est composé d'une couche en matériau ferromagnétique, par exemple un alliage de nickel et de fer, et a une épaisseur de l'ordre de 5*µ*m à 10*µ*m. Le plot de support 10 et la charnière 4 sont en chrome, en nickel, en or ou en alliage de chrome et nickel, en alliage de nickel et or ou, avantageusement, en alliage de chrome, nickel et or.

Par ailleurs, la tête 9 de la butée 7 est, par exemple, de forme bombée, circulaire et présente un diamètre supérieur à la largeur de la portion de support 12 d'une distance d de l'ordre de 2*µ*m. De telles dimensions permettent donc de déterminer un angle d'ouverture prédéterminé pour le bras pivotant 3, pour sa rotation autour de la charnière 4, jusqu'à venir en butée contre la tête 9 de la butée de fin de course 7 (figure 3).

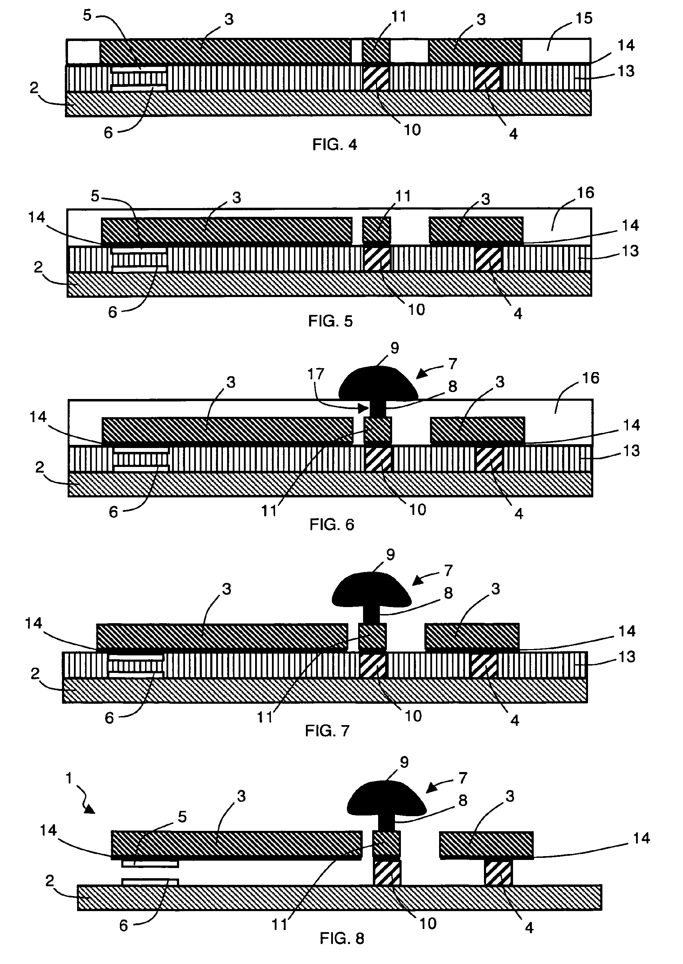

Un procédé de fabrication selon l'invention du microsystème 1, comme représenté sur les figures 2 et 3, va être décrit plus en détail au regard des figures 4 à 8. Sur la figure 4, le procédé comporte, dans une première étape, la formation des plots de contact fixe 6 sur la surface supérieure du substrat 2, puis, dans une deuxième étape, la formation de préférence simultanée, de la charnière 4 et des plots de support 10 des pieds 8 des butées de fin de course 7 (figure 3). Les plots de support 10 sont formés entre la charnière 4 et les plots de contact fixes 6, par structuration d'une première couche d'un même matériau, par exemple en chrome, en nickel, en or ou en alliage de chrome et nickel, déposée sur le substrat 2 et les plots de contact fixes 6 préalablement formés.

Sur la figure 4, une couche sacrificielle 13, par exemple en oxyde de silicium (SiO₂), formée, par exemple, par un dépôt chimique en phase vapeur assisté par plasma (communément appelé « Plasma Enhanced Chemical Vapor Déposition » ou PECVD en anglais) est ensuite formée, dans une troisième étape, autour de la charnière 4, des plots de support 10 et des plots de contact fixes 6. Dans une quatrième étape, une couche conductrice, par exemple en or, en nickel, en chrome, en platine ou en ruthénium, d'épaisseur de l'ordre de 0,1*µ*m à 1*µ*m, est ensuite déposée sur la couche sacrificielle 13, de manière à former au moins un plot de contact mobile 5 sur la surface inférieure du bras pivotant 3, destiné à venir en contact sur les plots de contact fixes 6 associés.

Sur la figure 4, dans une cinquième étape, le procédé comporte ensuite la formation du bras pivotant 3 dans une deuxième couche, par exemple en alliage de nickel et de fer, à partir d'une couche conductrice 14, par exemple en nickel, en or ou en alliage de nickel et de fer, d'épaisseur de l'ordre de 0,1*µ*m, déposée sur la couche sacrificielle 13 et structurée de manière à permettre un dépôt notamment par croissance électrolytique. Plus particulièrement, la cinquième étape consiste à déposer un masque 15 de résine photosensible, par exemple avec une épaisseur de l'ordre de 5*µ*m à 10*µ*m, sur la couche conductrice 14, le masque 15 étant partiellement ouvert selon la forme prédéterminée du bras pivotant 3 et du piédestal 11, prolongeant le plot de support 10, à réaliser. Puis, le bras pivotant 3 et le piédestal 11 du pied 8 de la butée de fin de course 7 sont formés, avantageusement, simultanément, par exemple, par dépôt électrolytique d'une couche en alliage de nickel et de fer.

Sur les figures 5 et 6, la couche conductrice 14 est avantageusement gravée selon la forme désirée, par l'intermédiaire d'un masque (figure 5), afin de conserver un contact électrique pour le piédestal 11. Puis, un masque 16, par exemple en résine photosensible, est déposé sur le bras pivotant 3 et le piédestal 11. Le masque 16 est ensuite gravé, de manière à former une ouverture 17 au niveau du piédestal 11 (figure 6).

Une troisième couche, par exemple en alliage de nickel et de fer, est alors déposée, par exemple, par dépôt électrolytique d'abord jusqu'à la limite supérieure du masque 16, pour former la portion de support 12 de la tête 9, constituant la troisième partie du pied 8 de la butée 7, et ensuite par débordement du matériau au-dessus du bras pivotant 3, pour former la tête 9 de la butée de fin de course 7.

Sur les figures 7 et 8, le masque 16 est ensuite éliminé, par exemple par gravure (figure 7), et le reliquat de la couche conductrice 14 est alors éliminé également par gravure. Enfin, dans une sixième étape, la couche sacrificielle 13 est éliminée, par exemple par gravure à l'acide fluorhydrique, afin de libérer le bras pivotant 3. Un microsystème 1 comme représenté schématiquement sur les figures 2, 3 et 8 est ainsi obtenu, avec la fabrication des butées de fin de course 7 réalisée de manière simple par des étapes de fabrication classiques en microélectronique, intégrées dans les étapes de fabrication du microsystème 1 lui-même. Il en résulte un gain en termes de temps et surtout en termes de coûts de fabrication.

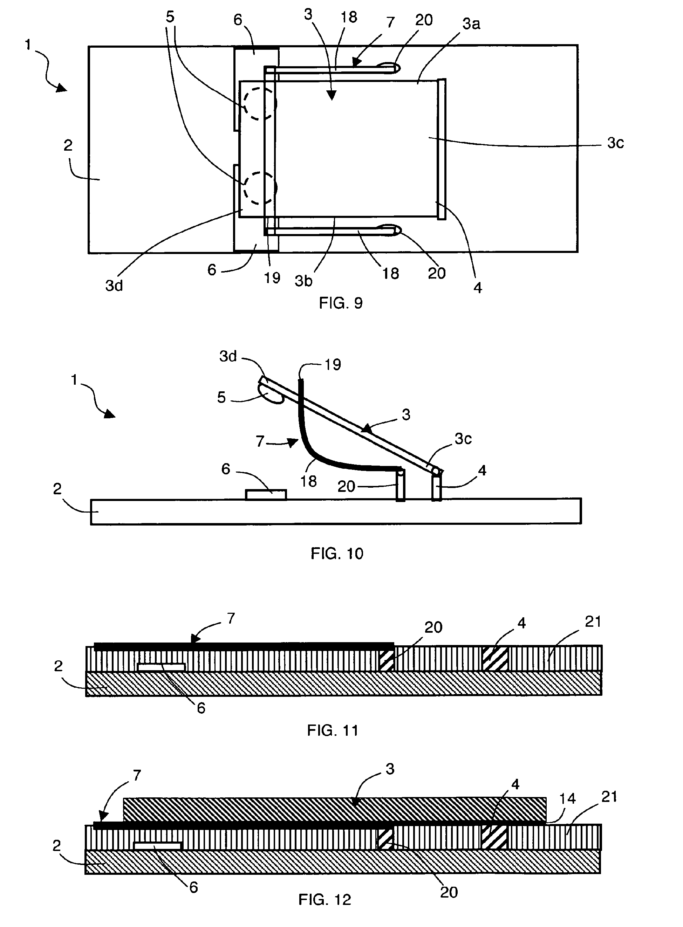

Dans la variante de réalisation de l'invention représentée sur les figures 9 à 13, le microsystème d'actionnement 1 selon l'invention se distingue du microsystème 1 représenté sur les figures 2 à 8 par la forme de la butée de fin de course 7 d'ouverture du bras pivotant 3.

Sur les figures 9 et 10, la butée de fin de course 7 est en forme de U, définissant sensiblement un portique comportant deux branches latérales 18 sous contrainte, reliées par une branche transversale 19, qui peut être dans un même matériau ou dans un matériau différent des branches latérales 18. Plus particulièrement, la branche transversale 19 est en tout matériau isolant, semi-conducteur ou conducteur non soluble dans l'acide fluorhydrique, par exemple du nitrure de silicium, du silicium, du nickel, du chrome, de l'or ou tout alliage à base de nickel, de chrome et d'or.

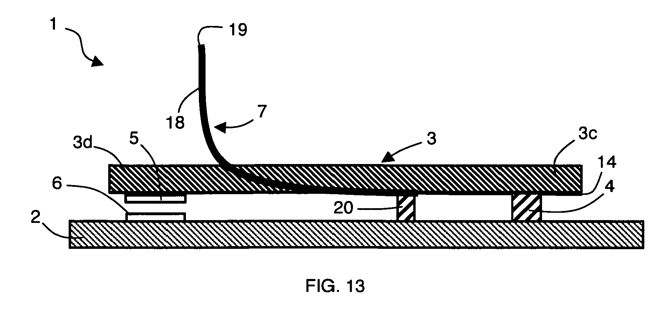

Le terme « sous contrainte » signifie qu'au moins les branches latérales 18 de la butée de fin de course 7 sont composées de couches de matériaux différents, c'est-à-dire ayant des coefficients de dilatation thermique différents ou des états de contraintes différents. Il en résulte alors leur déformation après relaxation des contraintes, leur permettant notamment de prendre une position sensiblement relevée au repos (figures 10 et 13), comme décrit notamment dans l'article « Effect of width on the stress-induced bending of micromachined bilayer cantilevers » de Max Ti-Kuang Hou et al. (J. Micromech. Microeng. 13 (2003) pp.141-148) et dans l'article « Curled micro-cantilevers using benzocyclobutene polymer and Mo for wafer level probing » de Si-Hyung Lee et al. (Sensors et Actuators A 121 (2005) pp.472-479).

Sur les figures 9 et 10, les branches latérales 18 sont disposées de part et d'autre du bras pivotant 3, parallèlement aux bords longitudinaux 3a, 3b, et ont une première extrémité reliée au substrat 2 par un plot de support 20 correspondant et une seconde extrémité reliée à la branche transversale 19. Les plots de support 20 sont disposés latéralement par rapport au bras pivotant 3 (figure 9), entre la charnière 4 et les plots de contact fixes 6, et les branches latérales 18 de la butée de fin de course 7 sont orientées de sorte que la branche transversale 19 est située à l'opposé de la charnière 4 (figure 10).

Les branches latérales 18 sont coudées vers le haut (figure 10) et la branche transversale 19 est disposée au-dessus et à distance du bras pivotant 3, entre l'extrémité 3c du bras pivotant 3, articulée sur la charnière 4, et l'extrémité libre 3d du bras pivotant 3, associée au plot de contact mobile 5.

La forme particulière relevée vers le haut des branches latérales 18, permettant à la branche transversale 19 d'être placée au-dessus du bras pivotant 3 et de servir de butée, pour bloquer la rotation du bras pivotant 3, est notamment due aux matériaux sous contrainte utilisés pour fabriquer la butée de fin de course 7, comme décrit ci-après.

Dans le mode particulier de réalisation représenté sur les figures 9 à 13, au moins les branches latérales 18 de la butée de fin de course 7 sont donc composées d'un empilement de couches sous contrainte, de préférence un empilement d'une couche en métal et d'une couche en polymère ou un empilement d'une couche en métal et d'une couche en nitrure de silicium.

À titre d'exemple, l'empilement composant la butée de fin de course 7 est composé d'une couche de nickel, par exemple avec une épaisseur de l'ordre de 0,1*µ*m, et d'une couche de nitrure de silicium, avec une épaisseur de l'ordre de 0,2*µ*m. Par ailleurs, comme précédemment, le bras pivotant 3 est composé, de préférence, d'une couche en matériau ferromagnétique, par exemple un alliage de nickel et de fer, et a une épaisseur de l'ordre de 5*µ*m à 10*µ*m.

À titre d'exemple, la butée de fin de course 7 peut être composée d'un empilement d'une couche de molybdène et d'une couche de benzocyclobutène (plus communément appelé BCB), notamment dans le cas où la butée de fin de course 7 est composée d'un empilement de couches sous contrainte différentielle, c'est-à-dire des couches ayant des coefficients de dilatation thermique différents ou des états de contraintes différents. En effet, les mécanismes de déformation par contrainte étant très liés aux modes d'élaboration des couches et à leurs propriétés mécaniques, les dimensionnements de dispositifs obtenus par simulations numériques s'avèrent peu pertinents. L'approche par itérations successives sur les épaisseurs et les comparaisons de jeux de formes à variation progressive permettent ainsi de définir une forme propre à assurer un blocage à une hauteur définie.

Un procédé de fabrication du microsystème 1, selon l'invention, comme représenté sur les figures 9 et 10, va être décrit plus en détail au regard des figures 11 à 13. Le procédé comporte, comme pour la variante de réalisation précédente, les six mêmes étapes, mais la fabrication de la butée de fin de course 7 s'effectue entre la troisième étape et la quatrième étape, à savoir après l'étape de formation d'une couche sacrificielle 21 (figure 11) et avant l'étape de formation d'une couche conductrice pour la réalisation de plots de contact mobiles 5 associés au bras pivotant 3 (figure 12).

Sur la figure 11, le procédé comporte donc d'abord la formation des plots de support 20 des branches latérales 18 de la butée de fin de course 7 et, de préférence simultanément, la formation de la charnière 4, sur laquelle est montée en rotation le bras pivotant 3. Puis, une couche sacrificielle 21, par exemple en oxyde de silicium, avec une épaisseur de l'ordre de 1*µ*m à 5*µ*m, est déposée, par exemple par PECVD. Un empilement de couches sous contrainte est ensuite déposé sur la couche sacrificielle 21 et gravé selon la forme souhaitée de la butée de fin de course 7, à savoir en forme de portique en U (figure 9).

Sur la figure 12, la couche conductrice 14 est ensuite déposée sur la couche sacrificielle 21, correspondant à la quatrième étape, et le bras pivotant 3 est ensuite formé, comme précédemment, sur la couche conductrice 14, par exemple par croissance électrolytique, entre les branches latérales 18 de la butée de fin de course 7.

Enfin, comme représenté sur la figure 13, après l'élimination de la couche sacrificielle 21, les contraintes dans l'empilement de couches composant la butée de fin de course 7 provoquent ainsi le relèvement de la butée de fin de course 7, avec la branche transversale 19 qui vient ainsi limiter mécaniquement la course verticale du bras pivotant 3 et les branches latérales 18 qui se courbent vers le haut. La branche transversale 19 vient ainsi se placer au-dessus de l'extrémité libre 3d du bras pivotant 3, entre l'extrémité libre 3d et l'extrémité 3c articulée sur la charnière 4 du bras pivotant 3.

Quel que soit le mode de réalisation décrit ci-dessus, le microsystème 1 selon l'invention comporte ainsi une butée de fin de course 7 efficace, avec une rotation du bras pivotant 3 limitée en fonction de la hauteur et de la position de la partie supérieure de la butée 7, laquelle est disposée au-dessus et à distance du bras pivotant 3, entre l'extrémité d'articulation 3c et l'extrémité libre 3d du bras pivotant 3. La hauteur et la position de la butée de fin de course 7 par rapport au bras pivotant 3 déterminent ainsi l'angle d'ouverture, à savoir l'amplitude de rotation possible, du bras pivotant 3 et le blocage du bras pivotant 3 est obtenu par l'appui sur une portion de la butée 7 venant se positionner en surplomb du bras pivotant 3.

Par ailleurs, l'avantage principal d'un tel microsystème 1, quel que soit le mode de réalisation représenté sur les figures 2 et 3 (première variante) et 9 et 10 (deuxième variante), réside dans le fait que la fabrication de la butée de fin de course 7 est intégrée dans les étapes de fabrication du microsystème 1 lui-même, quelle que soit la forme de la butée de fin de course 7. Le procédé selon l'invention propose ainsi de fabriquer la butée de fin de course 7 sur le substrat 2 supportant le bras pivotant 3, au cours du procédé de fabrication de celui-ci et à l'aide d'étapes de microélectronique. Ainsi, à l'aide des couches utilisées pour la fabrication du microsystème 1 et de l'addition de nouvelles étapes de fabrication, il est possible de réaliser une structure de blocage intégrée au support du microsystème, tout en maîtrisant l'angle d'ouverture possible du bras pivotant et en conservant le bénéfice de l'intégration.

Par ailleurs, un tel microsystème 1 selon l'invention (figures 2 à 13) présente également les avantages suivants. Le microsystème 1 ne nécessite pas de positionnement mécanique spécifique du bras pivotant 3 par rapport à la butée de fin de course 7. Le microsystème 1 est réalisé selon des techniques classiques en microélectronique, il en résulte une précision au micron des dimensions du microsystème 1 obtenu et une grande reproductibilité du procédé de fabrication.

Un tel procédé de fabrication selon l'invention (figures 2 à 13) est donc facile à mettre en oeuvre et ne nécessite aucun coût supplémentaire, notamment grâce à l'utilisation de techniques classiques en microélectronique et à l'intégration de la fabrication de la butée de fin de course pendant la fabrication du microsystème. Par ailleurs, il est possible de changer facilement l'amplitude de rotation du bras pivotant 3 sur le substrat 2, uniquement en changeant la forme et les dimensions des masques utilisés pour la fabrication du bras pivotant 3 et de la butée de fin de course 7, plus particulièrement pour la réalisation de la portion de support de tête 12 du pied 8, dans la première variante de réalisation (figures 2 à 8), et pour la réalisation de l'empilement sous contrainte des couches composant la butée 7, dans la deuxième variante de réalisation (figures 9 à 13).

Un tel microsystème d'actionnement et un tel procédé de fabrication selon l'invention s'appliquent notamment chaque fois qu'il convient de limiter la course d'un élément mobile sur un dispositif par des moyens intégrés à ce dispositif, plus particulièrement chaque fois que la partie mobile d'un interrupteur peut se déformer et ainsi nuire aux propriétés mécaniques de celui-ci. Ce type d'interrupteur peut se retrouver notamment dans des produits de type domestique, automobile, télécommunication, etc., où la miniaturisation apporte des avantages de fiabilité et de réduction de coûts.

L'invention n'est pas limitée aux différents modes de réalisation décrits ci-dessus. D'une façon générale, le microsystème 1 peut comporter tout type de butée de fin de course 7, solidaire du substrat, quelles que soient sa forme et ses dimensions, tant que la butée de fin de course 7 comporte une portion supérieure disposée au-dessus et à distance du bras pivotant 3, destinée à bloquer la rotation du bras pivotant 3, et une partie inférieure reliée au substrat et disposée latéralement par rapport au bras pivotant 3. Le microsystème 1 peut être réalisé par tout type de procédé de fabrication, de préférence tant que la fabrication de la butée de fin de course 7 est intégrée à la fabrication du microsystème 1 lui-même.

## Revendications

1. Microsystème d'actionnement (1) réalisé sur un substrat plan (2) et comportant au moins :
- un bras pivotant (3), monté en rotation autour d'une charnière (4) formée sur le substrat (2),
- un premier plot de contact fixe (6), disposé sur une surface supérieure du substrat (2) et coopérant avec au moins un plot de contact mobile (5), solidaire du bras pivotant (3),
- et une butée de fin de course (7) d'ouverture du bras pivotant (3),
microsystème **caractérisé en ce que** la butée de fin de course (7), formée sur le substrat, comporte :
- une partie supérieure disposée au-dessus et à distance du bras pivotant (3), entre une extrémité d'articulation (3c) du bras pivotant (3) sur la charnière (4) et une extrémité libre (3d) du bras pivotant (3), comportant le plot de contact mobile (5),
- une partie inférieure, reliée au substrat (2) et disposée latéralement par rapport au bras pivotant (3), entre la charnière (4) et le plot de contact fixe (6).

2. Microsystème selon la revendication 1, **caractérisé en ce que** le bras pivotant (3) comporte une couche en matériau ferromagnétique.

3. Microsystème selon la revendication 2, **caractérisé en ce que** le bras pivotant (3) comporte une couche en alliage de nickel et de fer.

4. Microsystème selon l'une quelconque des revendications 1 à 3, **caractérisé en ce que** le bras pivotant (3) a une épaisseur de l'ordre de 5*µ*m à 10*µ*m.

5. Microsystème selon l'une quelconque des revendications 1 à 4, **caractérisé en ce que** :
- la partie supérieure de la butée de fin de course (7) est constituée par une tête (9), faisant saillie au moins partiellement au-dessus d'un bord longitudinal (3a, 3b) du bras pivotant (3),
- la partie inférieure de la butée de fin de course (7) est constituée par un pied (8), comprenant un plot de support (10), formé sur le substrat (2), un piédestal (11) prolongeant le plot de support (10) et une portion de support (12) de la tête (9).

6. Microsystème selon la revendication 5, **caractérisé en ce que** le plot de support (10) est réalisé en un même matériau que la charnière (4), le piédestal (11) est réalisé en un même matériau que le bras pivotant (3) et la portion de support (12) de la tête (9) est réalisée en un même matériau que la tête (9).

7. Microsystème selon l'une des revendications 5 et 6, **caractérisé en ce que** la tête (9) et la portion de support (12) de la tête (9) de la butée de fin de course (7) sont réalisées en un matériau obtenu par dépôt électrolytique.

8. Microsystème selon l'une quelconque des revendications 5 à 7, **caractérisé en ce que** la portion de support (12) de la tête (9) de la butée de fin de course (7) a une épaisseur de l'ordre de 1*µ*m à 5*µ*m.

9. Microsystème selon l'une quelconque des revendications 5 à 8, **caractérisé en ce qu'**il comporte deux butées de fin de course (7a, 7b), disposées de part et d'autre de bords longitudinaux (3a, 3b) du bras pivotant (3).

10. Microsystème selon l'une quelconque des revendications 1 à 4, **caractérisé en ce que** la butée de fin de course (7) est en forme de U, comportant deux branches latérales (18) sous contrainte, constituant la partie inférieure de la butée de fin de course (7), disposées de part et d'autre du bras pivotant (3), coudées vers le haut et reliées par une branche transversale (19), constituant la partie supérieure de la butée de fin de course (7).

11. Microsystème selon la revendication 10, **caractérisé en ce que** les branches latérales (18) de la butée de fin de course (7) sont composées d'un empilement de couches sous contrainte.

12. Microsystème selon la revendication 11, **caractérisé en ce que** les branches latérales (18) de la butée de fin de course (7) sont composées d'un empilement d'une couche en métal et d'une couche en polymère.

13. Microsystème selon la revendication 11, **caractérisé en ce que** les branches latérales (18) de la butée de fin de course (7) sont composées d'un empilement d'une couche en métal et d'une couche en nitrure de silicium.

14. Microsystème selon la revendication 13, **caractérisé en ce que** les branches latérales (18) de la butée de fin de course (7) sont composées d'une couche de nickel, d'épaisseur de l'ordre de 0,1*µ*m, et d'une couche de nitrure de silicium, d'épaisseur de l'ordre de 0,2*µ*m.

15. Microsystème selon la revendication 11, **caractérisé en ce que** les branches latérales (18) de la butée de fin de course (7) sont composées d'un empilement d'une couche de molybdène et d'une couche de benzocyclobutène.

16. Microsystème selon l'une quelconque des revendications 10 à 15, **caractérisé en ce que** la branche transversale (19) est composée d'un empilement de couches sous contrainte.

17. Procédé de fabrication d'un microsystème (1), selon l'une quelconque des revendications 5 à 9, comportant successivement :
- une première étape, de formation d'au moins un plot de contact fixe (6) sur le substrat (2),
- une deuxième étape, de formation d'une charnière (4) et, entre la charnière (4) et le plot de contact fixe (6), d'au moins un plot de support (10) de la butée (7) dans une première couche déposée sur le substrat (2) et le plot de contact fixe (6),
- une troisième étape, de formation d'une couche sacrificielle (13) entre la charnière (4), le plot de support (10) et le plot de contact fixe (6),
- une quatrième étape, de formation d'au moins un plot de contact mobile (5) dans une couche conductrice,
- une cinquième étape, de formation d'un bras pivotant (3) par croissance électrolytique d'une deuxième couche à partir d'une couche conductrice (14), déposée sur le plot de contact mobile (5) et la couche sacrificielle (13),
- une sixième étape, d'élimination de la couche sacrificielle (13),
procédé **caractérisé en ce qu'**il comporte, entre la cinquième étape et la sixième étape, les étapes successives suivantes de :
- formation dans la deuxième couche, en même temps que le bras pivotant (3), d'un piédestal (11) prolongeant le plot de support (10),
- formation d'une ouverture (17) au niveau du piédestal (11), par dépôt et gravure d'un masque (16),
- formation d'une portion de support (12) de la tête (9) et d'une tête (9) de la butée de fin de course (7) du bras pivotant (3), par dépôt et structuration d'une troisième couche,
- élimination du masque (16).

18. Procédé de fabrication d'un microsystème (1), selon l'une quelconque des revendications 10 à 16, comportant successivement :
- une première étape, de formation d'au moins un plot de contact fixe (6) sur le substrat (2),
- une deuxième étape, de formation d'une charnière (4) et, entre la charnière (4) et le plot de contact fixe (6), d'au moins un plot de support (20) de la butée (7) dans une première couche déposée sur le substrat (2) et le plot de contact fixe (6),
- une troisième étape, de formation d'une couche sacrificielle (21) entre la charnière (4), le plot de support (20) et le plot de contact fixe (6),
- une quatrième étape, de formation d'au moins un plot de contact mobile (5) dans une couche conductrice,
- une cinquième étape, de formation d'un bras pivotant (3) par croissance électrolytique d'une deuxième couche à partir d'une couche conductrice (14), déposée sur le plot de contact mobile (5) et la couche sacrificielle (13),
- une sixième étape, d'élimination de la couche sacrificielle (13),
procédé **caractérisé en ce que** qu'il comporte, entre la troisième étape et la quatrième étape, la formation, par dépôt et structuration d'un empilement de couches sous contrainte, d'une butée de fin de course (7) en forme de U, comportant deux branches latérales (18), reliées par une branche transversale (19) et ayant chacune une extrémité solidaire d'un plot de support (20), l'élimination de la couche sacrificielle (21), lors de la sixième étape, provoquant le relèvement de la branche transversale (19) au-dessus de l'extrémité libre (3d) du bras pivotant (3).
